# EUROPEAN PATENT SPECIFICATION

(11) **EP 0 860 834 B1**
(45) Date of publication and mention of the grant of the patent: **29.03.2006**
(21) Application number: 98300462.3
(22) Date of filing: 22.01.1998
(51) Int. Cl.: H01B 1/22, H01B 1/24, C08K 3/00, C08L 27/18, H05K 9/00

(54) **Electrically conductive composite article**
Elektrisch leitender Verbundgegenstand
Objet composite électriquement conducteur

(30) Priority: 20.02.1997 US 827912
(43) Date of publication of application: 26.08.1998
(73) Proprietor: W.L. GORE & ASSOCIATES, INC., Newark, Delaware 19714 (US)
(72) Inventor: Hanrahan, James R., Newark, DE 19711 (US)
(74) Representative: Shanks, Andrew

(56) References cited:
- EP-A- 0 779 629
- WO-A-88/07063
- PATENT ABSTRACTS OF JAPAN vol. 013, no. 415 (M-870), 13 September 1989 & JP 01 152042 A (NOK CORP), 14 June 1989

## Description

The present invention generally relates to an improved, electrically conductive polytetrafluoroethylene article.

Electromagnetic interference (EMI) has been defined as undesired conducted or radiated electrical disturbances from an electrical or electronic apparatus, including transients, which can interfere with the operation of other electrical or electronic apparatus. Such disturbances can occur anywhere in the electromagnetic spectrum. Radio frequency interference (RFI) is often used interchangeably with electromagnetic interference, although it is more properly restricted to the radio frequency portion of the electromagnetic spectrum, usually defined as between 10 kilohertz (kHz) and 100 gigahertz (GHz).

A shield is defined as a metallic or otherwise electrically conductive configuration inserted between a source of EMI/RFI and a desired area of protection. Such a shield may be provided to prevent electromagnetic energy-from radiating from a source. Additionally, such a shield may prevent electromagnetic energy from entering a shielded system. As a practical matter, such shields normally take the form of an electrically conductive housing which is electrically grounded. The energy of the EMI/RFI is thereby dissipated harmlessly to ground.

Necessarily, most housings for electrical equipment are provided with access panels, hatches, doors or removable covers. Gaps which form between the panels, hatches, doors or removable covers provide an undesired opportunity for electromagnetic energy to leak into the shielded system. Such gaps also interfere with electrical current running along the surfaces of a housing. For example, if a gap is encountered, the impedance of the gap is such that electromagnetic energy may radiate from an opposed side of the gap, much like a slot antenna.

Various configurations of gaskets have been developed over the years to close the gaps of such shields and to effect the least possible disturbance of the ground conduction currents. Each seeks to establish as continuous as possible electrically conductive path across the gap(s). However, there are inevitable compromises between: the ability of the gasket to smoothly and thoroughly engage and conform to the surface of the housing adjacent the gaps; the conductive capacity of the gasket; the ease of mounting the gasket; and the cost of manufacturing and installing the gasket.

Presently, many electronic devices, such as but not limited to, pocket pagers, cellular phones, laptop computers and wireiess local area networks (LANs) are constructed using metallized plastic injection molded housings which are not manufactured to exact tolerances. Therefore, gaps form about the seams of an individual housing. Typically, in such devices mating housing members incorporate a snap-together method of closure, or in other instances, a limited number of light gauge screws are utilized to provide housing closure. Accordingly, most electronic devices having metallized plastic injected molded housings do not require substantial closure force to assemble a respective housing. Any shielded gasket which is incorporated into such electronic devices must be deformable or extremely conductive under a low compression force.

Conventionally, conductive particle-filled silicone elastomers have been utilized as conductive gaskets to reduce EMI and RFI. However, such materials tend to be relatively hard (e.g. Shore A hardness of about 60 or greater). Because of their hardness, conductive particle filled silicone elastomers are not well suited for use as a gasket in a device having a housing which is assembled with a substantially low closure force. Additionally, conductive particle filled silicone elastomers are difficult to manipulate when die cut into a thin gasket.

Other EMI/RFI shielding gaskets have been proposed which incorporate a conductive fabric or mesh which surrounds a soft, conformable foam material. Examples of such gaskets are disclosed in U.S. Patents 5,028,739; 5,115,104; 4,857,668; 5,045,635; 5,105,056; 5,202,526; and 5,294,270. Although the gaskets disclosed in the foregoing U.S. patents may be deformable under a low compression force, these gaskets do not have continuous conductivity throughout the material. Therefore, these gasket materials cannot be die cut into arbitrary shapes to function as an EMI/RFI gasket.

Seemingly, what the prior art lacks is an improved electrically conductive material which is extremely conductive under a low compressive load, and which is conformable and continuously conductive throughout the structure of the material such that the material is operable, in one application, to provide EMI shielding, in a frequency range from about 10 MHz to about 20 GHz, when used as a gasket between conductive seams.

It is an object of the present invention to provide an improved continuously electrically conductive polytetrafluoroethylene article for use in a variety of applications requiring a flexbile and continuously electrically conductive material throughout the entire structure of the article.

It is also an object of the present invention to provide an improved electrically conductive material for use as an EMI shielding gasket.

According to the present invention, there is provided an electrically conductive composite article consisting essentially of:
a main body having polytetrafluoroethylene material and a plurality of electrically conductive particles; and
an elastomer material disposed within said body, wherein said electrically conductive composite article has a shield effectiveness of at least 70dB in a frequency range from 0.01 GHz to 3GHz, at a pressure of 1724 kPa (250 psi); and wherein the article is continuously electrically conductive throughout its entire structure.

The electrically conductive compositive article of the present invention is permanently and continuously electrically conductive throughout its entire structure.

The electrically conductive particules may be selected from: metal powder, metal bead, metal fiber, metal flake, metal coated fiber, metal coated metals, metal coated ceramics, metal coated glass bubbles, metal coated glass beads, or metal coated mica flakes.

Suitable elastomer materials include but are not limited to: silicone elastomers, silicone rubbers, fluorosilicone elastomers, fluorocarbon elastomers, perfluoro elastomers, fluoroelastomers, polyurethane, or ethylene/propylene (EPDM).

Embodiments of the present invention will now be described, by way of example, with reference to the accompanying drawings, in which:
Figure 1 is a scanning electron micrograph showing a cross-sectional view of the electrically conductive composite article of the present invention;
Figure 2 is a scanning electron micrograph showing a plan view of a surface of the electrically conductive composite article of the present invention;
Figure 3 is a graph of shielding effectiveness (dB) versus frequency (Hz) for one embodiment of the electrically conductive composite article of the present invention, wherein the electrically conductive particles are nickel coated graphite particles;
Figure 4 is a graph of shielding effectiveness (dB) versus frequency (Hz) for one embodiment of the electrically conductive composite article of the present invention, wherein the electrically conductive particles are a mixture of silver flakes and silver coated glass beads; and
Figure 5 is a graph of shielding effectiveness (dB) versus frequency (Hz), for a comparative example of an efectridally conductive composite article, wherein the electrically conductive particles are carbon.

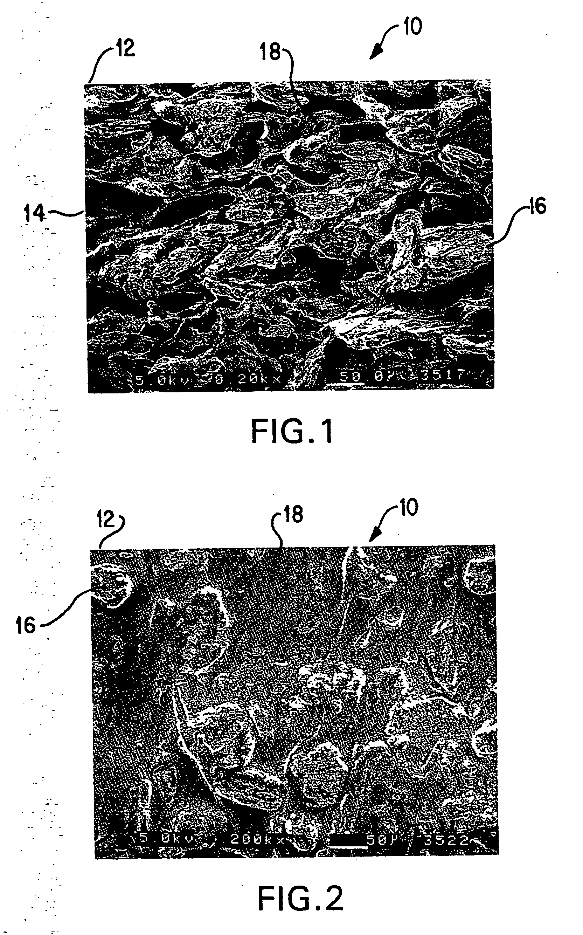

As best seen by reference to Figure 1, an electrically conductive composite article 10 has a main body 12 which may be dimensioned to form any predetermined shape. The main body 12 is defined by a polytetrafluoroethylene (PTFE) material 14 and a plurality of electrically conductive particles 16. Disposed within the main body 12 is an elastomer material 18.

The composite article of the present invention is permanently and continuously electrically conductive throughout its entire structure, (i.e. electric current will freely flow through the composite article of the present invention due to the low resistivity of the article). The electrically conductive composite article of the present invention may be effectively employed in a variety of useful applications, including but not limited to, an electrically conductive grounding and shielding material, battery and fuel cell applications, as a catalytic material, as a flow through electrode in electrolyte systems, instrumentation applications, electrofiltration applications, microwave applications, antenna systems or strip lines, for example.

In an application wherein the article of the present invention is employed as an electrically conductive shield, the article 10 is inserted between a source of EMI/RFI and a desired area of protection. Such a shield may be provided to prevent electromagnetic energy from radiating from a source. Additionally, such a shield may prevent electromagnetic energy from entering the shielded system.

In accordance with the present invention, the main body 12 is defined by a plurality of electrically conductive particles and PTFE in the form of paste dispersion or powder. The electrically conductive particles and PTFE are mixed in proportions to achieve a mixture containing 50 to 90 volume percent electrically conductive particles. Mixture may occur by any suitable means, including dry blending of powders, wet blending, co-coagulation of aqueous dispersions and slurry filler, or high shear mixing, for example:

As the term is used herein, "volume percent" shall mean a percentage of the total volume of a material or mixture.

Electrically conductive particles enmeshed within the resulting composite article of the present invention are a major component thereof. The electrically conductive particles may include, but are not limited to, metal powder, metal bead, metal fiber, or metal flake, or the particles may be defined by a metal coated particulate such as metal coated metals, metal coated ceramics, metal coated glass bubbles, metal coated glass beads, or metal coated mica flakes. Preferred conductive materials in particulate form include, but are not limited to, silver, nickel, aluminum, copper, stainless steel, graphite, carbon, gold, or platinum, for example. Preferred metal coatings include silver, nickel, copper, or gold. Additionally, a combination or mixture of two or more of the foregoing may be employed. Average size of the conductive flakes can be from 1 µm to 200µm, preferably from 1µm to 100µm, and most preferably from 20µm to 40µm. Average size for conductive powders can be from 0.5µm to 200µm, and most preferably from 2µm to 100µm.

The PTFE aqueous dispersion employed in producing the electrically conductive composite article of the present invention may be a milky-white aqueous suspension of PTFE particles. Typically, the PTFE aqueous dispersion will contain 20% to 70% by weight solids, the major portion of such solids being PTFE particles having a particle size in a range from 0.05 micrometers to 5.0 micrometers. Such PTFE aqueous dispersions are presently commercially available from the E. I. DuPont de Nemours Company, for example, under the tradename TEFLON® 3636, which is 18-24% by weight solids being for the most part PTFE particles of 0.05 micrometers to 5.0 micrometers.

An elastomer material, such as a silicone elastomer material (e.g. dimethyl siloxane), is disposed in a discontinuous fashion within the main body 12. This is achieved by compounding a filled fine powder coagulum of PTFE and electrically conductive particles with the elastomer material. A suitable dimethyl siloxane is Sylgard® type 1-4105, or Q1-4010, which may be obtained from Dow Corning. (It may also be suitable to use a silicon dioxide reinforced silicone material such as Q3-661 which may also be obtained from Dow Corning.)

The elastomer material, such as the dimethyl siloxane, is added on a weight per weight basis, and may be diluted with a solvent, such as mineral spirits, for example. In general, the elastomer material may be added in amounts ranging from 1 to 75 percent, preferably from 5 to 20 percent, and most preferably from 10 to 15 percent by weight of the mixture of elastomer and solvent. Other suitable elastomer materials include but are not limited to: silicone rubbers, fluorosilicone elastomers, fluorocarbon elastomers, perfluoro elastomers, fluoroelastomers, polyurethane, or ethylene/propylene (EPDM).

Subsequent to the addition of the elastomer material, the composite article is heated in a range from 130°C to 190°C, to catalyze the elastomer material into a cured state. The resulting composite article is a continuously electrically conductive composite article having a main body which may be dimensioned into any suitable shape or thickness.

The addition of the elastomer material yields a continuously electrically conductive composite article with an increased z-strength and tensile strength. The elastomer also provides some degree of resilience. These desired properties are achieved without sacrificing electrical conductivity.

The following procedures were used to determine the properties of the materials created in accordance with the following examples.

### Volume Resistivity

The volume resistivity was measured with round silver probes, one square inch in area. In order to achieve a measurement for uncompressed volume resistivity, a one pound weight was put on the probes to yield the resistance of the sample at one pound per square inch (psi). Heavier weights were employed to measure resistance of the composite article of the present invention at various compression levels. The conversion from resistance to volume resistivity is as follows:$ϑ = \frac{R A}{L} ( Ω ⋅ cm ) ;$ where:
ϑ = Volume resistivity;
R = Resistance in ohms;
A = Area of sample (cm²); and
L = Thickness of sample (cm).

### Density

Density was obtained by using a 1" x 6" template to cut a sample exactly 1" x 6". The sample was then weighed to the nearest .01 grams and the density calculated as follows: $D ( g / cc ) = \frac{M}{V} ;$ where:
M = Mass of sample to nearest .01 grams; and
V = Volume (Length x width x thickness).

### Shielding Effectiveness

Shielding effectiveness was calculated by the following method:
Shielding Effectiveness = 20 log (τ); where:
   τ = Transmission Coefficient magnitude;
   τ = Vₒᵤₜ/Vᵢₙ;
   Vₒᵤₜ = Voltage at the output; and
   Vᵢₙ = Voltage at the input.

The transmission coefficient was measured using a Hewlett-Packard type 8752A network analyzer. The test fixture used was based on a test fixture described in test method ARP-1705, however, the test fixture used was modified to work with the network analyzer. More particularly, since the transmission coefficient was directly measured by the network analyzer, a reference resistor was not used in conjunction with the fixture. Also, in order to yield the shielding effectiveness of the gasket under test without any contribution due to the fixture, the physical dimensions of the fixture were optimized for maximum transmissivity when no gasket was in place, and a normalization procedure was used to further remove the effect of the fixture.

Without intending to limit the scope of the present invention, the electrically conductive composite article of the present invention may be better understood by referring to the following examples:

### Example 1

11,060 g of nickel coated graphite (type 2224 from Westaim Corp.) was slurried in 65.5 liters of de-ionized water. The slurry was then coagulated with 7,654 g of PTFE dispersion at 26.0% solids. (Type TE-3636 from E. I. DuPont de Nemours and Company.) The resulting coagulum was then dried at 90°C for 24 hours. The coagulum was then frozen at -10°C for a minimum of 13 hours, and screened into a powder form through a 1/4" mesh metal screen. The powder was then lubricated with a mixture containing 75% by weight polysiloxane (Sylgard® type 4105 obtained from Dow Corning, Inc.) and 25% by weight mineral spirits. The lubrication level was 0.25 pounds lubricant per pound of coagulum. This material was then refrozen at -10°C for a minimum of 18 hours, and hand-screened through a 1/4" mesh screen to remove any large lumps of lubed coagulum. The resulting lubricated powder was then allowed to dwell at ambient room conditions for a minimum of 24 hours. The material was then preformed into a 4" diameter pellet, and extruded into tape form approximately 140 mils thick. The extrudate was then calendered to 24 mils thick and 400 feet long. The tape was then continuously heated to 190°C at a rate of five feet per minute. The material was then measured to determine the following properties:

| | |
|---|---|
| Vol. resistivity (1 psi) | = 46.3 Ω cm |
| (50 psi) | = .087 Ω cm |
| (250 psi) | = .020 Ω cm |
| Density | = 1.95 g/cc |

A sample of this material was then die cut into an annular ring having the following dimensions:

| | |
|---|---|
| Inside diameter | = 1.92" |
| Outside diameter | = 2.00" |

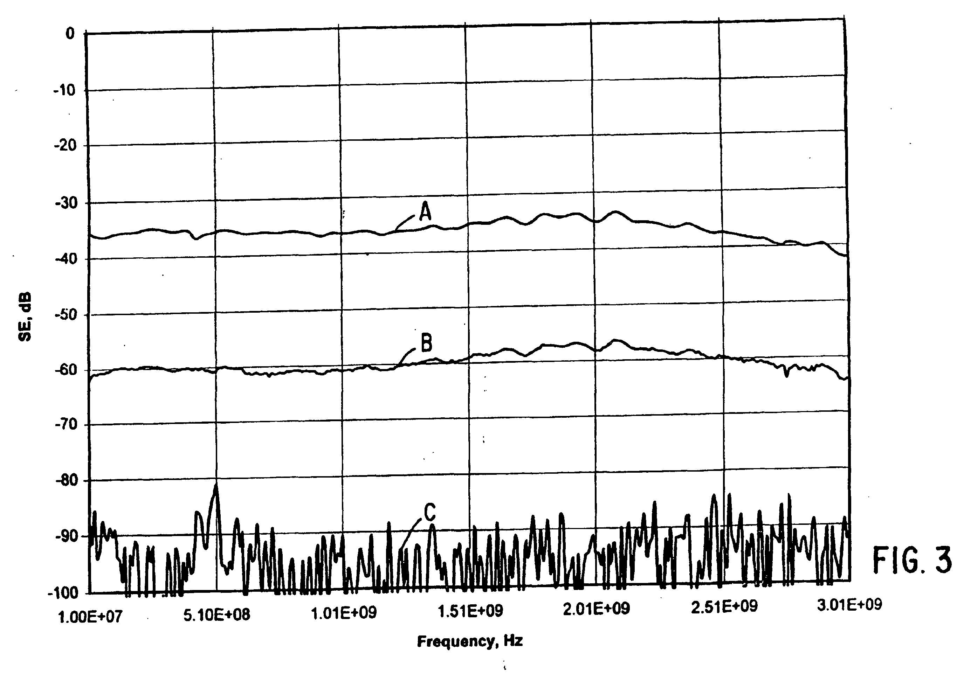

The shielding effectiveness (S.E.) of the annular ring was then measured. Results were determined and are graphically illustrated in Figure 3.

Figure 3 represents the shielding effectiveness versus the frequency, from a range of 1x10⁷ to 3x10⁹ Hz. The S.E. was calculated for three different pressures. Line A represents the S.E. at 1 psi. Line B represent the S.E. at 50 psi. Line C represents the S.E. at 250 psi. A summation of the results follows:
At 1 psi, the S.E., which can be seen in Figure 3 and is represented by line A, maintained a relatively constant S.E. throughout the tested frequency spectrum. The S.E. ranged from below -30 to about -40 dB., except for at very high frequency levels where the S.E. dropped below -40 dB.
At 50 psi, the S.E., represented by line B, acted similarly to line A, maintaining a relatively constant S.E. The S.E. leveled at about -60 dB., throughout the entire spectrum.
At 250 psi the S.E., represented by line C, averaged in a range below -90 dB., throughout the entire spectrum.

### Example 2

3,200 g of silver coated class beads (Metalite SF-20 obtained from PQ Industries) and 6,955 g of silver flake (Type 450 obtained from Technic, Inc.) was slurried in 12,395 g of IPA and 49,583 g de-ionized water. The slurry was then coagulated with 12,202 g of PTFE dispersion at 22.8% solids. (Type TE-3636 from E.I. DuPont de Nemours and Company). The resulting coagulum was then frozen at -10°C for a minimum of 18 hours and screened into powder form through a 1/4" mesh metal screen. The powder was then lubricated with a mixture containing 50% by weight polysiloxane (Sylgard® type 4105 obtained from Dow Coming, Inc.) and 50% by weight mineral spirits. The lubrication level was 0.20 pounds lubricant per pound coagulum. This material was then re-frozen at -10°C for a minimum of 18 hours, and hand screened again through a 1/4" mesh metal screen. The resulting lubricated powder was then allowed to dwell at ambient room conditions for a minimum of 24 hours. The material was then preformed into a 2.5" diameter pellet, and extruded into tape form approximately 50 mils thick and 4" wide. The tape was then calendered to 10 mils-thick. Subsequently, the tape was heated to 150°C for two minutes and the following properties were measured:

| | |
|---|---|
| Vol. resistivity (1 psi) | =.34 Ω cm |
| (50 psi) | = 0.044 Ω cm |
| (250 psi) | = 0.017 Ω cm |
| Density | = 1.50 g/cc |

A sample of this material was then die cut into an annular ring having the following dimensions:

| | |
|---|---|
| Inside diameter | = 1.92" |
| Outside diameter | = 2.00" |

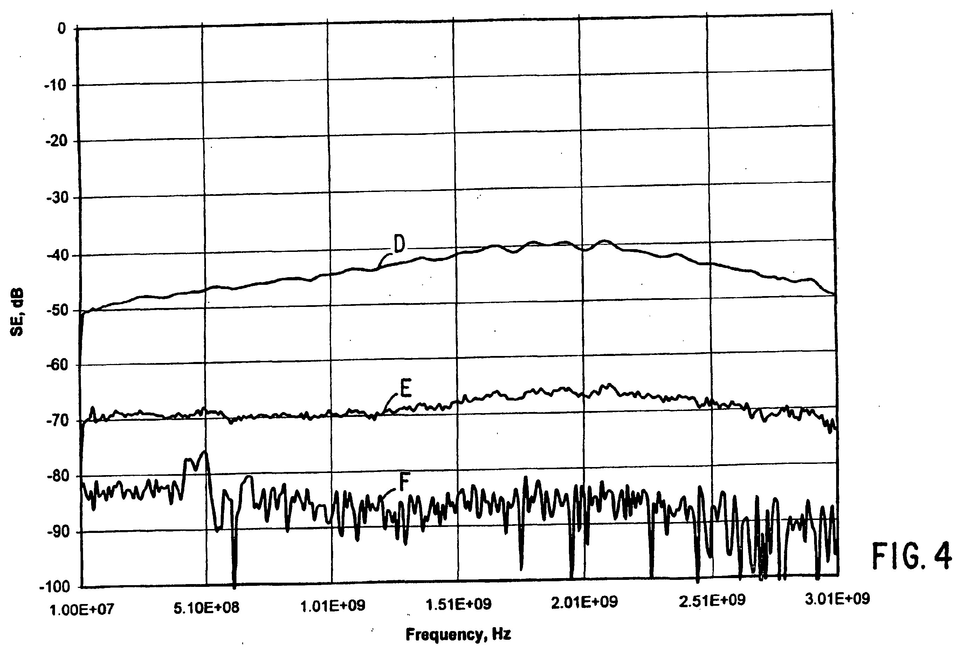

The shielding effectiveness (S.E.) of the annular ring was then measured. Results were determined and are graphically illustrated in Figure 4.

Figure 4 represents the shielding effectiveness versus the frequency, from a range of 1x10⁷ to 3x10⁹ Hz. The S.E. was calculated for three different pressures. Line D represents the S.E. at 1 psi. Line E represent the S.E. at 50 psi. Line F represents the S.E. at 250 psi. A summation of the results follows:
At 1 psi, the S.E., which can be seen in Figure 4 and is represented by line D, maintained an average level below -40 dB.
At 50 psi, the S.E., represented by line E, maintained a relatively constant S.E., at about -70 dB., throughout the entire spectrum, except for an increase in dB., from about 1.51x10⁹ to about 2.01x10⁹ Hz., where the S.E. began to decrease and finally drop below -70 dB., at about 2.51x10⁹ Hz.
At 250 psi the S.E., represented by line F, averaged in a range below -80 dB., throughout the entire spectrum.

### Comparative Example 3

3.81 pounds of Ketjenblack E300J (obtained from Akzo Chemical) was slurried in 22,406 grams of de-ionized water. The slurry was then coagulated with 16.0 pounds of PTFE dispersion (type TE-3636 obtained from E.I. DuPont de Nemours and Company) at 23.8% solids. The coagulum was then dried at 165°C for about 24 hours. The frozen cakes were the forced through a 1/4" mesh metal screen to make into powder. A lubricant of mineral spirits was added. The lubricated powder was then re-frozen for approximately 24 hours and re-screened. The resulting lubricated powder was then allowed to dwell at ambient room conditions for a minimum of 24 hours and preformed into a 4" diameter pellet. The pellet was heated to 49°C and extruded into a tape form 6" wide and approximately 45 mils thick. The tape was then calendered to 16 mils thick, and dried in a continuous fashion above 180°C at a rate to 15 fpm. The tape was then tested to determine the following properties:

| | |
|---|---|
| Vol. resistivity (1 psi) | = 12.2 Ω cm |
| (50 psi) | = 2.0 Ω cm |
| (250 psi) | = 0.22 Ω cm |

A sample of this material was then die cut into an annular ring having the following dimension:

| | |
|---|---|
| Inside diameter | = 1.92" |
| Outside diameter | = 2.00" |

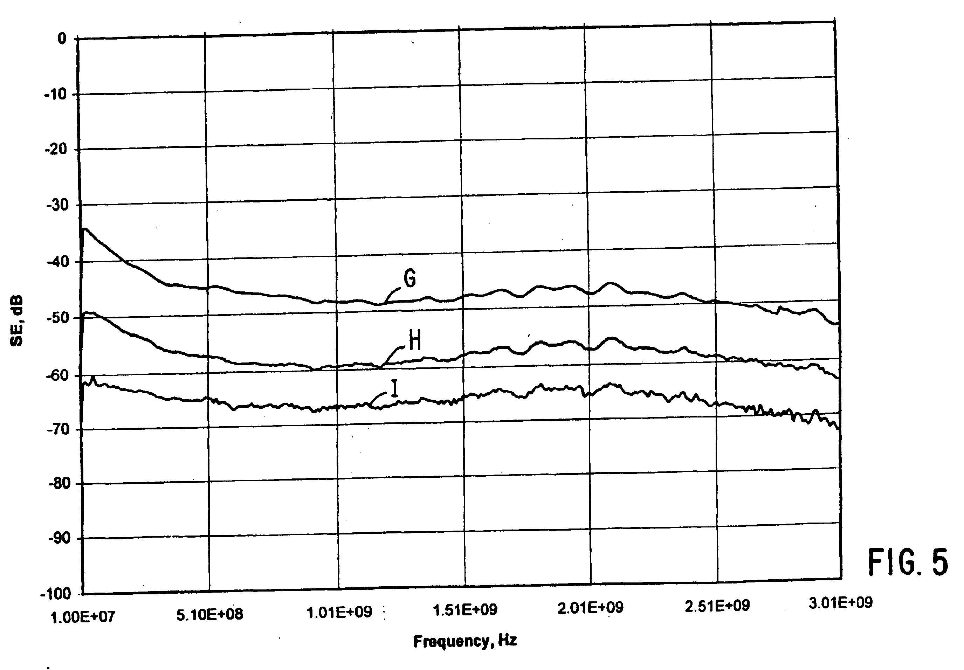

The shielding effectiveness (S.E.) of the annular ring was then measured. Results were determined and are graphically illustrated in Figure 5.

Figure 5 represents the shielding effectiveness versus the frequency, from a range of 1x10⁷ to 3x10⁹ Hz. The S.E. was calculated for three different pressures. Line G represents the S.E. at 1 psi. Line H represent the S.E. at 50 psi. Line I represents the S.E. at 250 psi. A summation of the results follows:
At 1 psi, the S.E., which can be seen in Figure 5 and is represented by line G, maintained on average a level of about -45 dB., throughout the tested frequency spectrum.
At 50 psi, the S.E., represented by line H, maintained, on average, a level of about -55 dB.
At 250 psi the S.E., represented by line I, maintained, on average, a level of about -65 dB.

## Claims

1. An electrically conductive composite article consisting of:
a main body having polytetrafluoroethylene material and a plurality of electrically conductive particles; and
an elastomer material disposed within said body in a discontinuous fashion,
wherein said electrically conductive composite article has a shield effectiveness of at least 70dB in a frequency range from 0.01 GHz to 3 GHz, at a pressure of 1724 kPa (250 psi); and wherein the article is continuously electrically conductive throughout its entire structure.

2. An article as claimed in claim 1, wherein the electrically conductive particles are selected from:
metal powder, metal bead, metal fiber, metal flake, metal coated fiber, metal coated metals, metal coated ceramics, metal coated glass bubbles, metal coated glass beads, or metal coated mica flakes.

3. An article as claimed in claim 1, wherein the electrically conductive particles are selected from:
silver, nickel, aluminium, copper, stainless steel, graphite, carbon, gold, or platinum particles.

4. An article as claimed in claim 2 or 3, wherein the electrically conductive particles define a mixture of at least two of said selected electrically conductive particles.

5. An article as claimed in claim 1 or 2, wherein the electrically conductive particles are in the form of metal flakes having an average size in a range from 1 to 200 microns.

6. An articles as claimed in claim 1 or 2, wherein the particles are in the form of a metal powder having a particle size in a range from 0.5 to 200 microns.

7. An article as claimed in any preceding claim, wherein the elastomer material is selected from: silicone elastomers, silicone rubbers, fluorosilicone elastomers, fluorocarbon elastomers, perfluoro elastomers, fluoroelastomers, polyurethane, or ethylene/propylene (EPDM).

8. An article as claimed in claim 7, wherein the elastomer material is dimethyl siloxane.

9. An article as claimed in claim 7, wherein the elastomer material is reinforced with silicon dioxide.

10. Use of an article according to any preceding claim in any of the following: an electrically conductive grounding and shielding material; battery and fuel cell applications; catalytic materials; flow through electrodes in electrolyte systems; instrumentation applications; electrofiltration applications; microwave applications; antenna systems; and strip lines.

11. A method of forming a flexible electrically conductive composite article comprising the following steps:
a. mixing electrically conductive particles and polytetrafluoroethylene to form a mixture containing 50 to 90 volume percent electrically conductive particles; and thereafter
b. mixing elastomer material with the mixture of electrically conductive particles and polytetrafluoroethylene wherein the elastomer material is disposed in a discontinuous fashion in the article; and
c. performing a heating step to catalyse the elastomer material into a cured state;
wherein the formed electrically conductive composite article has a shield effectiveness of at least 70dB in a frequency range from 0.01 GHz to 3 GHz, at a pressure of 1724 kPa (250 psi); and wherein the article is continuously electrically conductive throughout its entire structure.

12. A method according to claim 11, wherein the elastomer material is diluted in a solvent.

13. A method according to claim 12, wherein the elastomer material is added in a range of 10 to 15 percent by weight of the mixture of elastomer and solvent.

14. A method according to any of claims 11 to 13, wherein the heating step to catalyse the elastomer material into a cured state occurs at 130°C to 190°C.

## Patentansprüche

1. Elektrisch leitfähiger Verbundgegenstand bestehend aus:
einem Hauptkörper mit Polytetrafluorethylen-Material und einer Mehrzahl elektrisch leitfähiger Partikel; und
einem Elastomermaterial, das in dem Körper in ungleichmäßiger Weise verteilt ist,
wobei der elektrisch leitfähige Verbundgegenstand eine Abschirmwirksamkeit von mindestens 70 dB in einem Frequenzbereich von 0,01 GHz bis 3 GHz bei einem Druck von 1724 kPa (250 psi) hat; und wobei der Gegenstand überall in seinem ganzen Gefüge kontinuierlich elektrisch leitfähig ist.

2. Gegenstand wie in Anspruch 1 beansprucht, bei dem die elektrisch leitfähigen Partikel ausgewählt sind aus: Metallpulver, Metallkügelchen, Metallfaser, Metallplättchen, metallbeschichteter Faser, metallbeschichteten Metallen, metallbeschichteten Keramiken, metallbeschichteten Glasblasen, metallbeschichteten Glaskügelchen oder metallbeschichteten Glimmerplättchen.

3. Gegenstand wie in Anspruch 1 beansprucht, bei dem die elektrisch leitfähigen Partikel ausgewählt sind aus: Partikeln aus Silber, Nickel, Aluminium, Kupfer, rostfreiem Stahl, Graphit, Kohlenstoff, Gold oder Platin.

4. Gegenstand wie in Anspruch 2 oder 3 beansprucht, bei dem die elektrisch leitfähigen Partikel ein Gemisch von mindestens zwei der ausgewählten elektrisch leitfähigen Partikel definieren.

5. Gegenstand wie in Anspruch 1 oder 2 beansprucht, bei dem sich die elektrisch leitfähigen Partikel in der Form von Metallplättchen mit einer durchschnittlichen Größe in einem Bereich von 1 bis 200 µm befinden.

6. Gegenstand wie in Anspruch 1 oder 2 beansprucht, bei dem sich die Partikel in der Form eines Metallpulvers mit einer Partikelgröße in einem Bereich von 0,5 bis 200 µm befinden,

7. Gegenstand wie in irgendeinem vorangehenden Anspruch beansprucht, bei dem das Elastomermaterial ausgewählt ist aus: Silikon-Elastomeren, Silikon-Kautschuken, Fluorsilikon-Elastomeren, Fluorkohlenstoff-Elastomeren, Perfluor-Elastomeren, Fluorelastomeren, Polyurethan oder Ethylen/Propylen (EPDM).

8. Gegenstand wie in Anspruch 7 beansprucht, bei dem das Elastomermaterial Dimethyl-siloxan ist.

9. Gegenstand wie in Anspruch 7 beansprucht, bei dem das Elastomermaterial mit Siliciumdioxid verstärkt ist.

10. Verwendung eines Gegenstands nach irgendeinem vorangehenden Anspruch bei irgendeiner der folgenden Anwendungen: ein elektrisch leitfähiges Erdungs- und Abschirmmaterial; Batterie- und Brennstoffzellen-Anwendungen; katalytische Materialien; Durchflußelektroden in Elektrolytsystemen; Geräteausrüstungs-Anwendungen; Elektrofiltrations-Anwendungen; Mikrowellen-Anwendungen; Antennensysteme: und Bandleitungen.

11. Verfahren zur Herstellung eines flexiblen, elektrisch leitfähigen Verbundgegenstands, folgende Schritte aufweisend:
a. Mischen von elektrisch leitfähigen Partikeln und Polytetrafluorethylen, um ein Gemisch zu bilden, das 50 - 90 Vol.% elektrisch leitfähige Partikel enthält; und danach
b. Mischen von Elastomermaterial mit dem Gemisch von elektrisch leitfähigen Partikeln und Polytetrafluorethylen, wobei das Elastomermaterial in ungleichmäßiger Weise in dem Gegenstand verteilt wird; und
c. Durchführen eines Erhitzungsschritts, um das Elastomermaterial in einen gehärteten Zustand zu katalysieren;
wobei der hergestellte elektrisch leitfähige Verbundgegenstand eine Abschirmwirksamkeit von mindestens 70 dB in einem Frequenzbereich von 0.01 GHz bis 3 GHz bei einem Druck von 1724 kPa (250 psi) hat; und wobei der Gegenstand überall in seinem gesamten Gefüge kontinuierlich elektrisch leitfähig ist.

12. Verfahren nach Anspruch 11, bei dem das Elastomermaterial in einem Lösungsmittel verdünnt wird.

13. Verfahren nach Anspruch 12, bei dem das Elastomermaterial in einem Bereich von 10 bis 15 Gew.% des Gemisches von Elastomer und Lösungsmittel zugegeben wird.

14. Verfahren nach einem der Ansprüche 11 bis 13, bei dem der Erhitzungsschritt zur Katalyse des Elastomermaterials in einen gehärteten Zustand bei 130° C bis 190° C stattfindet.

## Revendications

1. Objet composite électriquement conducteur constitué :
d'un corps principal comprenant un matériau de polytétrafluoréthylène et une pluralité de particules électriquement conductrices ; et
d'un matériau élastomère disposé à l'intérieur dudit corps, d'une façon discontinue,
dans lequel ledit objet composite électriquement conducteur présente une efficacité de blindage de 70 dB au moins dans une plage de fréquences comprises entre 0.01 GHz et 3 GHz, à une pression de 1724 kPa (250 livres par pouce carré) ; et dans lequel l'objet est électriquement conducteur de manière continue dans toute sa structure.

2. Objet selon la revendication 1, dans lequel les particules électriquement conductrices sont sélectionnées parmi : une poudre métallique, des perles métalliques, des fibres métalliques, des paillettes métalliques, des fibres enduites de métal, des métaux enduits de métal, des céramiques enduites de métal, des bulles de verre enduites de métal, des perles de verre enduites de métal, ou des paillettes de mica enduites de métal.

3. Objet selon la revendication 1, dans lequel les particules électriquement conductrices sont sélectionnées parmi : des particules d'argent, de nickel, d'aluminium, de cuivre, d'acier inoxydable, de graphite, de carbone, d'or, ou de platine.

4. Objet selon les revendications 2 ou 3, dans lequel les particules électriquement conductrices définissent un mélange de deux au moins desdites particules électriquement conductrices sélectionnées.

5. Objet selon les revendications 1 ou 2, dans lequel les particules électriquement conductrices se présentent sous la forme de paillettes métalliques ayant une taille moyenne qui se situe dans une plage comprise entre 1 micromètre et 200 micromètres.

6. Objet selon les revendications 1 ou 2, dans lequel les particules se présentent sous la forme d'une poudre métallique dont les particules ont une taille qui se situe dans une plage comprise entre 0,5 micromètre et 200 micromètres.

7. Objet selon l'une quelconque des revendications précédentes,
dans lequel le matériau élastomère est sélectionné parmi : les élastomères silicones, les caoutchoucs silicones, les élastomères fluorosilicones, les élastomères fluorocarbones, les élastomères perfluoro, les fluoroelastomères, le polyuréthane, ou l'éthylène / propylène (EPDM).

8. Objet selon la revendication 7, dans lequel le matériau élastomère est du diméthyle siloxane,

9. Objet selon la revendication 7, dans lequel le matériau élastomère est renforcé par de l'oxyde de silicium.

10. Utilisation d'un objet selon l'une quelconque des revendications précédentes dans n'importe laquelle parmi les applications suivantes : un matériau électriquement conducteur de mise à la masse et de blindage ; des applications de batterie et de piles à combustible ; des matériaux catalytiques ; des électrodes à flux continu dans des systèmes d'électrolyte ; des applications d'instrumentation ; des applications d'électrofiltration ; des applications micro-onde ; des systèmes d'antenne ; et des lignes ruban.

11. Procédé pour former un objet composite électriquement conducteur flexible comprenant les étapes suivantes consistant à :
a. mélanger des particules électriquement conductrices et du polytétrafluoréthylène pour former un mélange qui contient entre 50 à 90 pour cent en volume de particules électriquement conductrices ; et ensuite
b. mélanger un matériau élastomère avec le mélange de particules électriquement conductrices et de polytétrafluoréthylène dans lequel le matériau élastomère est disposé d'une façon discontinue dans l'objet ; et
c. exécuter une étape de chauffage pour catalyser le matériau élastomère dans un état durci ;
dans lequel l'objet composite électriquement conducteur formé présente une efficacité de blindage de 70 dB au moins dans une plage de fréquences comprises entre 0.01 GHz et 3 GHz, à une pression de 1724 kPa (250 livres par pouce carré) ; et dans lequel l'objet article est électriquement conducteur de manière continue dans toute sa structure.

12. Procédé selon la revendication 11, dans lequel le matériau élastomère est dilué dans un solvant.

13. Procédé selon la revendication 12, dans lequel le matériau élastomère est ajouté dans une proportion comprise entre 10 et 15 pour cent en poids du mélange de l'élastomère et du solvant.

14. Procédé selon l'une quelconque des revendications 11 à 13, dans lequel l'étape de chauffage pour catalyser le matériau élastomère dans un état durci se produit dans une plage de températures comprise entre 130 °C et 190 °C.
